# EUROPÄISCHE PATENTANMELDUNG

(11) **EP 0 521 238 A1**
(43) Veröffentlichungstag der Anmeldung: **07.01.1993**
(21) Anmeldenummer: 92102744.7
(22) Anmeldetag: 19.02.1992
(51) Int. Cl.: H04B 1/40, H03D 7/16

(54) **Frequenzaufbereitungsschaltung für Funkgeräte**

(30) Priorität: 02.07.1991 DE 4121830
(71) Anmelder: ROBERT BOSCH GMBH, 70442 Stuttgart (DE)
(72) Erfinder: Hof, Manfred, Dipl.-Ing., W-1000 Berlin 13 (DE)

(57) **Zusammenfassung**

2.1 Eine bekannte Frequenzaufbereitungsschaltung setzt neben einem Digital/Analog-Wandler-gesteuerten Referenzfrequenzoszillator zwei PLL-Oszillatorschaltungen voraus, von denen die eine PLL-Oszillatorschaltung die Sendefrequenz und eine erste Frequenz und die andere PLL-Oszillatorschaltung eine zweite Frequenz für die Demodulation des Empfangssignals liefert.

2.2 Nach der Erfindung wird die Referenzfrequenz (f_{R}) des Referenzfrequenzoszillators (12) so gewählt, daß sie einem Mischer und Demodulator (20) unmittelbar zugeführt werden kann, wodurch die Frequenzaufbereitungsschaltung nur noch eine PLL-Oszillatorschaltung (17) benötigt.

2.3 Die Frequenzaufbereitungsschaltung eignet sich insbesondere für ein Mobilfunksystem nach dem GSM-Standard.

3. Die Zeichnung zeigt ein vereinfachtes Blockschaltbild einer Frequenzaufbereitungsschaltung.

## Beschreibung

Die Erfindung geht von einer Frequenzaufbereitungsschaltung nach dem Oberbegriff des Anspruchs 1 aus.

Es ist eine derartige Frequenzaufbereitungsschaltung bekannt, die bei Mobiltelefonen für das Netz C der Deutschen Bundespost eingesetzt wird. Diese Schaltung enthält üblicherweise einen Digital/Analog-Wandler-gesteuerten Referenzoszillator, einen ersten PLL-Oszillator zum Erzeugen der Sendefrequenz und der Oszillatorfrequenz für den Mischer des Empfängers sowie einen zweiten PLL-Oszillator und einen damit verbundenen Demodulator.

Der Erfindung liegt die Aufgabe zugrunde, die Frequenzaufbereitungsschaltung nach dem Oberbegriff des Anspruchs 1 derart weiterzubilden, daß bei möglichst geringem technischen Aufwand eine Frequenzaufbereitungsschaltung entsteht, die sich für Mobiltelefone für das digitale Netz D der Deutschen Bundespost bzw. für den GSM-Standard eignet.

Diese Aufgabe wird durch die in dem Anspruch 1 angegebenen Merkmale gelöst. Mit der Erfindung ist der Vorteil verbunden, daß die Frequenzaufbereitungsschaltung mit einem Digital/Analog-Wandler-gesteuerten Referenzoszillator und nur einer PLL-Oszillatorschaltung und einem Demodulator auskommt, um die in einem Mobiltelefon benötigten Frequenzen bereitzustellen und das niederfrequente Basisband zurückzugewinnen.

Ausführungsbeispiele der Erfindung sind in der Zeichnung an Hand zweier Figuren dargestellt und werden im folgenden näher erläutert. Es zeigen
- Fig. 1: ein vereinfachtes Blockschaltbild einer erfindungsgemäßen Frequenzaufbereitungsschaltung und
- Fig. 2: ein ausführlicheres Blockschaltbild nach Fig. 1.

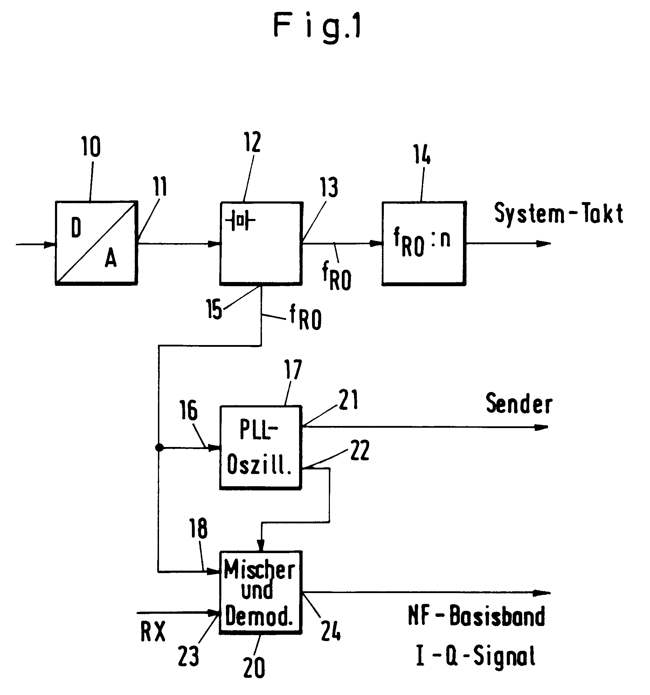

Eine Frequenzaufbereitungsschaltung für Netz-D-(GSM)-Mobiltelefone enthält nach Fig. 1 einen Digital/Analog-Wandler, dessen analoger Ausgang 11 mit einem durch den Wandler gesteuerten Referenzfrequenzoszillator 12 verbunden ist. Ein erster Ausgang 13 des Referenzfrequenzoszillators 12 steht mit einem Teiler 14 und ein zweiter Ausgang 15 mit einem Eingang 16 einer PLL-Oszillatorschaltung 17 und einem Eingang 18 eines Mischers und Demodulators 20 in Verbindung. Ein erster Ausgang 21 der PLL-Oszillatorschaltung 17 ist mit dem Sender des Mobiltelefons und ein zweiter Ausgang 22 mit dem Mischer und Demodulator 20 des Empfängers verbunden. Einem weiteren Eingang 23 des Mischers und Demodulators 20 wird das Empfangssignal RX zugeführt. An einem Ausgang 24 des Mischers und Demodulators steht das demodulierte NF-Basisband bzw. das dekodierte I-Q-Signal zur Verfügung. Die Referenzfrequenz f_{RO} des Referenzfrequenzoszillators 12 wird so gewählt, daß sie ein Vielfaches eines Systemtaktes von zum Beispiel 13 MHz und einer neu zu bestimmenden Zwischenfrequenz f_{Z} ist. Vorteilhafterweise wird die Zwischenfrequenz f_{Z} in die Nähe der Frequenz eines handelsüblichen Zwischenfrequenz-Filters und in die Nähe eines Duplexabstandes von zum Beispiel 45 MHz gelegt. Unter Berücksichtigung der vorstehenden Bedingungen ergibt sich im vorliegenden Fall für den Referenzfrequenzoszillator 12 eine Referenzfrequenz f_{RO} = 91 MHz und eine Zwischenfrequenz f_{Z} = 45,5 MHz. Innerhalb des Empfangszeitschlitzes im Netz-D/GSM-System mit dem Duplexabstand von 45 MHz muß somit eine Frequenzkorrektur des Sender- und Empfängeroszillators des Mobiltelefons von 500 kHz vorgenommen werden. Diese Korrektur hat sich in der zur Verfügung stehenden Zeit als durchführbar erwiesen. Die Systemreferenzfrequenz f_{RS} = 13 MHz erhält man, indem die Referenzfrequenz f_{RO} = 91 MHz mit dem Teiler 14 durch n = 7 dividiert wird.

Als Mischer und Demodulator 20 eignet sich vorzugsweise ein integrierter Baustein vom Typ PMB 2400 (Siemens).

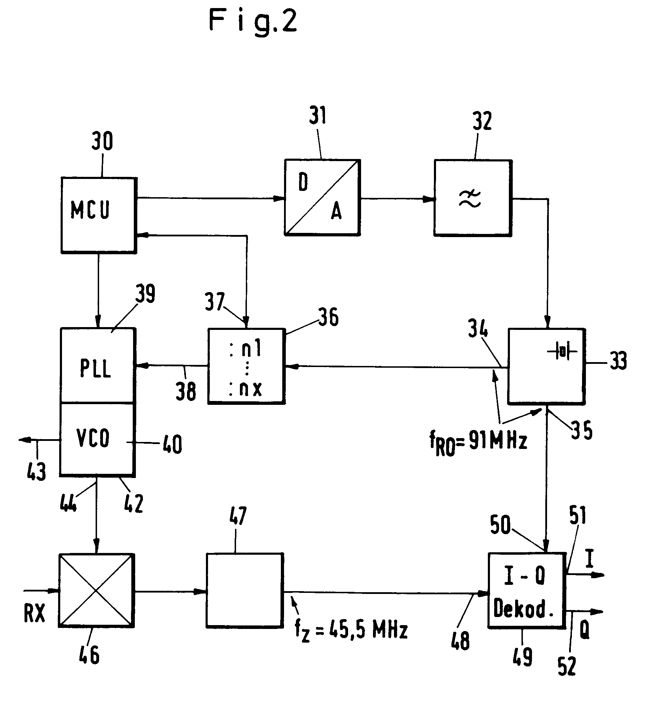

In dem ausführlichen Blockschaltbild einer Frequenzaufbereitungsschaltung nach Fig. 2 bezeichnet 30 eine Mikroprozessorschaltung, an die ein Digital/Analog-Wandler 31 angeschlossen ist, der über ein Tiefpaßfilter 32 mit einem Digital/Analog-Wandler-gesteuerten Referenzfrequenzoszillator 33 verbunden ist. Von zwei Ausgängen 34, 35 des Referenzfrequenzoszillators 33 steht der erste Ausgang 34 mit einem Frequenzteiler 36 in Verbindung, dessen erster Anschluß 37 mit der Mikroprozessorschaltung 30 und dessen Ausgang 38 mit einem PLL-Synthesizer 39 verbunden ist, der zusammen mit einem spannungsgesteuerten Oszillator 40 eine PLL-Schaltung 42 bildet. Der spannungsgesteuerte Oszillator 40 hat einen ersten Ausgang 43, der mit dem Sendermodulator des Mobiltelefons in Verbindung steht, und einen zweiten Ausgang 44, der mit einem ersten Eingang eines Mischers 46 verbunden ist. Ein zweiter Eingang des Mischers 46 dient zum Zuführen des Empfangssignals RX. Ein Ausgang des Mischers 46 gibt die mit dem Mischer gebildete Zwischenfrequenz f_{Z} ab, die über ein auf die Zwischenfrequenz abgestimmtes Zwischenfrequenz-Filter 47 an einen ersten Eingang 48 eines I-Q-Signal-Dekoders 49 gelangt, dessen zweiten Eingang 50 die von dem Referenzfrequenzoszillator 33 gelieferte Referenzfrequenz f_{RO} zugeführt wird. Der Dekoder 49 hat zwei Ausgänge 51 und 52 für ein I- bzw. Q-Signal und ist vorzugsweise ein integrierter Baustein mit der Bezeichnung PMB 2400 (Siemens). An die Stelle des Dekoders 49 kann auch ein Demodulator treten.

## Patentansprüche

1. Frequenzaufbereitungsschaltung für Funkgeräte mit einem Referenzfrequenzoszillator und einem PLL-Oszillator zum Bereitstellen einer Sendefrequenz und einer Zwischenfrequenz, **dadurch gekennzeichnet,** daß die Referenzfrequenz (f_{RO}) des Referenzfrequenzoszillators (12) so gewählt wird, daß sie dem Mischer und Demodulator (20) des Empfängers unmittelbar zugeführt werden kann.

2. Frequenzaufbereitungsschaltung nach Anspruch 1 für ein Mobilfunksystem nach dem GSM-Standard, dadurch gekennzeichnet, daß die Referenzfrequenz (f_{RO}) bei einem Systemtakt von 13 MHz, einem Duplexabstand von 45 MHz und einer Zwischenfrequenz f_{Z} von 45,5 MHz 91 MHz beträgt.
